# EUROPEAN PATENT APPLICATION

(11) **EP 4 815 654 A1**
(43) Date of publication of application: **30.09.2026**
(21) Application number: 25460011.7
(22) Date of filing: 26.03.2025
(51) Int. Cl.: H05K 7/20, H01J 37/32, H01L 23/427

(54) **HP-HV-PULSED POWER SUPPLY AND A METHOD OF COOLING OF SUCH AN HP-HV-PULSED POWER SUPPLY**

(71) Applicant: TRUMPF Huettinger Sp. z o.o., 05-220 Zielonka (PL)
(72) Inventor: The designation of the inventor has not yet been filed
(74) Representative: Trumpf Patentabteilung

(57) **Abstract**

The HP-HV-pulsed power supply (1) for a plasma process, said HP-HV-pulsed power supply (1) comprising:
a. an electrical input (21) to receive electrical power from an electrical grid (22),
b. an electrical output (23) to deliver a pulsed ultra high voltage (26),
c. a plurality of electrical components (6), each configured to generate a moderate high voltage (27) between two connection points (20), and being capable to generate heat when the HP-HV-pulsed power supply (1) is in use,
d. a container (2) with a basin (3), wherein said plurality of electrical components (6) are placed in the basin (3),
e. an electrically insolating heat transfer liquid (9) in the basin (3), surrounding and having direct contact to the electrical components (6), wherein the electrically insolating heat transfer liquid (9) is configured to evaporate under the influence of heat from the electrical components (6) to the form of vapor (15), the vapor (15) being able to rise up in the container (2), to transport heat away from the electrical components (6),
f. a condenser pipe (4), fillable with a cooling fluid (5), and configured that the vapor (15) may condense on the condenser pipe (4) and may get back to the basin (3), wherein
h. the HP-HV-pulsed power supply (1) is configured to deliver electrical power with a pulsed ultra high voltage (26) with a peak output voltage of 2 kV or more, and
i. said plurality of electrical components (6) are connected electrical in series, so that, in use of the HP-HV-pulsed power supply (1), the peak output voltage will be divided over those components (6) and the highest amount of moderate voltage (27) over each of two connection points of those components (6) is lower than the peak output voltage by a factor of 2 or more.

## Description

The invention is related to a HP-HV-pulsed power supply for a plasma process and a method of cooling of such an HP-HV-pulsed power supply.

HP shall be the abbreviation for high power. With high power is meant an output power of at least 10 kW - 100 kW during a pulse-on time.

HV shall be the abbreviation for high voltage. With high voltage is meant an output voltage of at least 8 kV - 22 kV during a pulse-on time.

A "plasma process" designates any process in which a plasma is used, for example, a plasma etching process, a plasma deposition process, a plasma cleaning process, a plasma surface treatment process, a plasma polymerization process.

In plasma processes, particularly those involving high-power high-voltage (HP-HV) pulsed power supplies, there is a significant challenge associated with heat management. The excessive heat generated by the electrical components during operation can lead to several problems such as reduced performance, potential damage to components, and increased maintenance requirements. Traditional cooling methods often fail to dissipate this heat effectively, resulting in localized overheating and thermal stress. This inefficiency in thermal management is problematic as it can compromise the reliability and longevity of the power supply system.

The application provides solutions for the challenges associated with excessive heat generation in electrical components during operation, which can lead to reduced performance, potential damage, and increased maintenance requirements. Traditional cooling methods may not effectively dissipate heat, resulting in localized overheating and thermal stress.

In electronic applications with electrical components, it can be useful to arrange the electrical components in a cooling chamber and to fill the cooling chamber with a cooling liquid. The electrical components are then surrounded by the cooling liquid. Such cooling is also known as direct liquid cooling (DLC).

Electronic application may be a high-power generator that needs cooling. In WO2024240705A1 the advantageous use of a direct liquid cooling for such a high-power generator is described. By using direct liquid cooling, clearance and creepage requirements can be reduced. This allows better utilization of the safe operating range of all components, resulting in a size reduction and thus a reduction in parasitic reactance, such as e.g., capacity and/or inductivity. Thus, a smaller high-power generator and increased efficiency can be achieved through direct liquid cooling.

In WO2023161509A1, a direct liquid cooling is also described. In this patent application an electronic device comprising a plurality of electrical components capable to generate heat, a container, where electrical components are placed and an electrically insolating heat transfer liquid, filled within said container and having direct contact to the electrical components to transport heat away from those electrical components.

However, the use of direct liquid cooling is insufficient when voltages become higher and higher.

This application addresses the problem of inefficient heat management in HP-HV-pulsed power supplies used in plasma processes.

It is the object of the invention to present an HP-HV-pulsed power supply for a plasma process with quick and efficient heat management. An enhanced cooling arrangement for the HP-HV-pulsed power supply is essential for maintaining the stability and efficiency of plasma processes, preventing overheating, and ensuring the longevity of the equipment.

According to a first aspect the HP-HV-pulsed power supply comprises an electrical input to receive electrical power from an electrical grid and an electrical output to deliver a pulsed ultra high voltage.

The pulsed ultra high voltage refers to a high-voltage electrical signal that is characterized by short-duration pulses of extremely high voltage.

The HP-HV-pulsed power supply may be configured to deliver electrical power with a pulsed ultra high voltage with a peak output voltage of 2 kV or more, in particular 5 kV or more.

The duration of the pulses may be in the range of 100 ns - 1 µs.

The electrical input provides a stable and consistent source of electrical power, minimizing interruptions and ensuring continuous operation and the electrical output provides intense bursts of energy, enabling efficient operation of high-power applications and improves the effectiveness of processes that require rapid and powerful electrical pulses, leading to better results and outcomes.

In an aspect, the HP-HV-pulsed power supply comprises a plurality of electrical components, each configured to generate a moderate high voltage between two connection points. The highest amount of moderate voltage is lower than the peak output voltage by a factor of 2 or more.

In an aspect, the HP-HV-pulsed power supply comprises an electrical component or a plurality of electrical components capable to generate heat when the HP-HV-pulsed power supply is in use. An electrical component should be understood as a component being a part of a power supply with an electrical current running through it, when the power supply is in use, for example, a transistor, a diode, a capacitor, an inductivity. A plurality of electrical components should be understood as a combination of, for example, transistors, diodes, capacitors, inductivities being a functional part of a power supply.

The HP-HV-pulsed power supply further comprises a container with a basin. The container may be understood as a cabinet, where the most parts of the HP-HV-pulsed power supply are arranged inside, in particular most of the electrical components capable to generate heat are arranged inside. The term "container" is used here, because this container is a closed cabinet. The basin may be understood as a reservoir being configured to be filled with a fluid. The basin may be a part of the container. It is not necessary to arrange two separate parts, a container and a basin. Just the lower part of the container may be the basin, if this lower part of the container has the features of the basin as described here.

In an aspect, the container may be, at least when in use, a completely closed container. So, seals may be provided to seal the container. In such a way, no air or fluid can go out or in from or into the container.

In the container, an air environment may above the basin.

At least a part of the plurality of electrical components are placed in the basin. The HP-HV-pulsed power supply further comprises an electrically insolating heat transfer liquid, surrounding and having direct contact to those electrical component(s). The electrically insolating heat transfer liquid is configured to evaporate under the influence of heat from the electrical component or components to the form of vapor, which rises up the basin, to transport heat away from these electrical component or components.

The HP-HV-pulsed power supply further comprises a condenser pipe, fillable with a cooling fluid, configured that the vapor may condense on the condenser pipe and may get back to the basin.

The "getting back" to the basin may be a "falling back", e.g. as droplets or jet. It may also be a "leading back" along a fluid guidance, such as a runoff, gutter, or gully.

Such a fluid guidance may be arranged and configured to lead the condensed vapor to the basin.

The condenser pipe may be arranged above the basin.

The condenser pipe may be arranged in the air environment.

The HP-HV-pulsed power supply further is configured to deliver electrical power with a pulsed ultra high voltage with a peak output voltage of 2 kV or more.

The HP-HV-pulsed power supply further comprises plurality of electrical components connected electrical in series, so the peak output voltage will be divided over those components. The highest amount of moderate voltage over each of two connection points of those components is lower than the peak output voltage by a factor of 2 or more.

In such a way, the above-mentioned object can be accomplished in a reliable way.

The HP-HV-pulsed power supply further comprises an insolating heat transfer liquid characterized by a breakdown voltage in a field in which both, electrically insolating heat transfer liquid and bubbles of vapor. Electrical discharges may occur when the voltage across two points, with a predetermined distance within such a field, is higher than the breakdown voltage, wherein the predetermined distance corresponds to the shortest distance between two connection points of one of the components.

With "the predetermined distance corresponds to the shortest distance between two connection points" is meant, that the predetermined distance may be equal to the shortest distance between two connection points.

In such a way, the above-mentioned object can be accomplished in a reliable way.

In an aspect, the HP-HV-pulsed power supply may be configured that the highest amount of moderate voltage over two connection points of all components is lower than the said breakdown voltage.

In such a way, the above-mentioned object can be accomplished in a reliable way.

In an aspect, the HP-HV-pulsed power supply may be configured that the pulsed ultra high voltage may get higher than this breakdown voltage.

In such a way, the above-mentioned object can be accomplished in a reliable way.

In an aspect, the HP-HV-pulsed power supply may further comprise a first pipe, a heat exchanger and a second pipe. In an aspect, the first pipe, the heat exchanger and the second pipe arranged in a continuous circuit fillable with the cooling fluid, so that in use the cooling fluid conducts the heat generated by the component(s) outside the container .

In such a way, the above-mentioned object can be accomplished in a reliable way.

In an aspect, the HP-HV-pulsed power supply may comprise the condenser pipe in the form of a spiral.

In such a way, the above-mentioned object can be accomplished in a reliable way.

In an aspect, the HP-HV-pulsed power supply may comprise the container as a completely closed container.

In such a way, the above-mentioned object can be accomplished in a reliable way.

In an aspect, the HP-HV-pulsed power supply further comprises a pressure management system configured to keep the pressure inside the container in a predefined range.

In such a way, the above-mentioned object can be accomplished in a reliable way.

In an aspect, the HP-HV-pulsed power supply further comprises a pressure management system configured to keep the pressure inside the container through valve with condenser.

With a pressure range may be meant a range of pressure values, such as e.g., from 2 bar to 3 bar.

A HP pulsed power supply with a pressure management system is disclosed, e,g., in WO2024240705A1 which is incorporated into this disclosure in its entirety. In that disclosure is also disclosed a degassing management. Such a or a similar degassing management may be also beneficial for this HP pulsed power supply. A completely closed container is for that very helpful.

In an aspect, the pressure management system may be implemented by means of an opening and closing valve with condenser to maintain the predefined range of pressure.

In such a way, the above-mentioned object can be accomplished in a reliable way.

In an aspect, the HP-HV-pulsed power supply may comprise an electrically insolating heat transfer liquid is a fluorocarbon-based fluid.

In such a way, the above-mentioned object can be accomplished in a reliable way.

In an aspect, the HP-HV-pulsed power supply may comprise a wall comprises a layer with boiling enhancement coating.

A boiling enhancement coating refers to a specialized surface treatment applied to a substrate to improve its boiling heat transfer characteristics.

In an aspect, the coating may enhance the heat transfer coefficient by providing a higher density of nucleation sites, leading to more efficient boiling and delays the transition to film boiling, allowing for higher heat fluxes before reaching the critical heat flux point.

In an aspect, the modified surface may improve the wettability of the liquid, promoting better contact and heat transfer between the liquid and the surface and increases the surface roughness, which aids in the formation and release of vapor bubbles, improving boiling performance.

In an aspect, the coating can be tailored to specific applications and working fluids, making it suitable for a wide range of industrial and electronic cooling applications.

The disclosed system utilizes a two-phase cooling mechanism involving an electrically insulating heat transfer liquid that evaporates to vapor, e.g. in the form of bubbles, rising to the surface of the liquid, and the rising to the top of the container and thereby transports heat away from the electrical component(s) in a very effective manner. This is followed by condensation on a cooling pipe, arranged preferably at the top of the container, thereby enhancing the overall thermal management within the container. This approach aims to maintain enhanced operating temperature and improve the reliability and longevity of the power supply system. With the cooling pipe, the heat may be transported outside of the container and dissipated or used for other facilities with high efficiency.

In such a way, the above-mentioned object can be accomplished in a reliable way.

Moreover, with respect to the method, the object of the invention is achieved by a method of cooling an HP-HV-pulsed power supply, in particular a HP-HV-pulsed power supply for a plasma process, said method comprising the steps of:
- a heating step, in which an electrical component, or a plurality of electrical of components, is or are heated,
- an evaporating step, in which the heat generated by the component(s) causes an electrically insolating heat transfer liquid to evaporate and the electrically insolating heat transfer liquid is transported upward in the form of vapor,
- a vapor condenser step in which the vapor settles on a condenser pipe, which is filled with cooling fluid,
- a heat receiving step in which the cooling fluid, under the action of warm vapor, heats up and receives the heat of vapor through the condenser pipe,
- a heat dissipating step in which the cooling fluid in condenser pipe is in continuous circulation and thus dissipates heat from container via first pipe to heat exchanger,
- a fluid fed back step in which the cooling fluid from heat exchanger is fed to the condenser pipe via second pipe,
- a vapor condensed vapor getting back step in which the cooled vapor condenses back into the form of a liquid and falls as droplets into the volume of the liquid.

In such a way, the above-mentioned object can be accomplished in a reliable way.

The present disclosure is illustrated by way of example and not limited in the accompanying figures in which like reference numerals indicate similar elements. Embodiments of the application will now be described with reference to the attached drawings:
Fig. 1 shows an HP-HV-pulsed power supply with a cooling system.
Fig. 2 shows an HP-HV-pulsed power supply with a cooling system with schematical effect of evaporation.
Fig. 3a and 3b shows electronic components with two evaporations effects.
Fig. 4 shows schematic block of a method of cooling system.

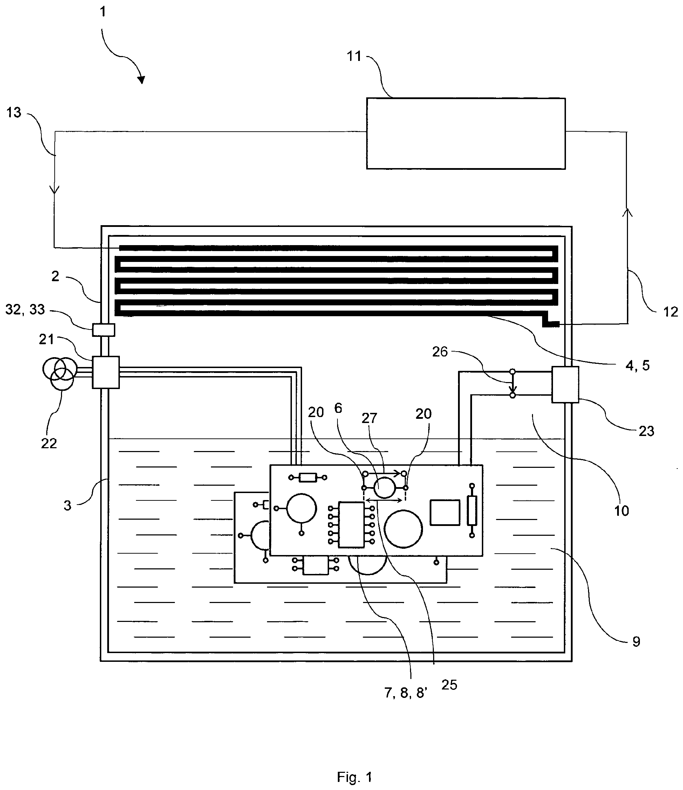

Fig. 1 shows an HP-HV-pulsed power supply 1 with a cooling arrangement. The cooling arrangement comprises a container 2, a basin 3 and a condenser pipe 4 with a cooling fluid 5 circuit in an air 10 environment. The container 2 may be completely closed. Inside a basin 3 electronic components 6 are arranged. Some of the components 6 may be arranged with a wall 7 and additional layer 8 and, in particular with a boiling enhancement coating 8'. These components, at least a part of electronic components 6 are submerged in an electrically insolating heat transfer liquid 9 and electronic components 6 may being capable to generate heat when the HP-HV-pulsed power supply 1 is in use.

The cooling fluid 5 refers to a fluid specifically formulated or selected for its ability to absorb and dissipate heat efficiently. This cooling fluid 5 may be used in various cooling systems to transfer thermal energy away from heat-generating components, thereby maintaining optimal operating temperatures. The cooling fluid 5 may possess properties such as high thermal conductivity, low viscosity, and chemical stability to enhance its performance. The cooling fluid 5 may be water, ethylene glycol, propylene glycol, mineral oil, silicone oils, fluorocarbon oils.

The electrically insolating heat transfer liquid 9 refers to a fluid specifically formulated or selected for its ability to absorb and dissipate heat efficiently.

The electrically insolating heat transfer liquid 9 may be a non-flammable, low-toxic, dielectric fluids with relatively low boiling point (below 100 °C). Three heat transfer fluids were selected for tests for the cooling arrangement. Two of them are delivered by 3M: Novec 7100 and Novec 649. Third fluid is Galden HT55 manufactured by Solvay, but the electrically insolating heat transfer liquid 9 may be also ethylene glycol, propylene glycol, mineral oil, silicone oils, fluorocarbon oils.

The use of the electrically insulating heat transfer liquid 9 may provide the advantage of maintaining fluidity, ensuring effective heat management without electrical interference.

The direct contact between the electrical components 6 and the electrically insolating heat transfer liquid 9 may enhance the heat absorption efficiency, allowing for rapid and effective cooling during high-power operations.

The HP-HV-pulsed power supply 1 may provide the advantage of improved heat transfer efficiency, enhancing the overall performance of the system.

The system's design may allow for the advantage of maintaining liquidity of the heat transfer liquid, which is crucial for efficient two-phase cooling.

The condenser pipe 4 may be in the form of a spiral.

The spiral form of the condenser pipe 4 increases the surface area available for heat exchange, which can lead to more effective condensation of the vapor 15 and faster cooling of the system.

The spiral design can also facilitate a more uniform distribution of cooling fluid 5 within the condenser pipe 4, enhancing the overall thermal management of the power supply.

The compactness of the spiral condenser pipe 4 can contribute to a reduction in the overall size of the power supply, making it more suitable for applications with space constraints.

The HP-HV-pulsed power supply 1 may also comprises a first pipe 12, a heat exchanger 11 and a second pipe 13. The first pipe 12, the heat exchanger 11 and the second pipe 13 are connected to each other and arranged in a continuous circuit fillable with the cooling fluid 5. In use the cooling fluid 5 conducts the heat generated by the component(s) 6 outside the container 2.

The heat exchanger 11 is outside of the container.

The first pipe 12 and the second pipe 13 are leading the cooling fluid 5 outside of the container 2.

The first pipe 12 is leading the cooling fluid 5 from the the container 2 to the heat exchanger 11.

The second pipe 13 is leading the cooling fluid 5 from the heat exchanger 11 to the container 2.

The container 2 design may ensure that the heat transfer process is contained, minimizing the risk of exposure to external environments and potential contaminants that could affect the performance and safety of the HP-HV-pulsed power supply 1.

The heat exchanger 11 refers to a device or apparatus designed to transfer thermal energy between two or more fluids without mixing them. This may occur in the heat exchanger 11 through a solid barrier or surface that separates the fluids, allowing efficient thermal exchange. The heat exchanger 11 are commonly used in various applications, including heating, cooling, and energy recovery systems. The heat exchanger 11 may utilize materials with high thermal conductivity to enhance heat transfer efficiency and may include features such as baffles, fins, or corrugated surfaces to increase the surface area for heat exchange.

The electronic components 6 may have an electrical input 21 to receive electrical power from an electrical grid 22 and an electrical output 23 to deliver a pulsed ultra high voltage 26.

The electrical input 21 refers to the electrical power that is supplied to a device, system, or component for the purpose of operation, control, or processing. This input may be in the form of voltage, current, or power, and is typically received from an external source.

The electrical input 21 may also include a signal port.

In the electrical input 21 or nearby the electrical input 21 may be arranged a ore several filter components. Those filter component(s) may have two effects. Firstly, they may enhance the stability of the power supply by decreasing disturbing voltage spikes or electromagnetic waves which may come from outside the container. Secondly, they may reduce disturbing electromagnetic waves which are developed inside the container before they come out. So, they help to reduce electromagnetic disturbing into the grid or environment.

In the electrical input 21 or nearby the electrical input 21 may be arranged a ore several measuring components. Those measuring component(s) may help a control to manage the power supplied. Voltage drops may be detected very early, e.g. and an appropriate measure against fall out of output power may be performed very fast.

The electrical grid 22 is a network of interconnected electrical power generation, transmission, and distribution systems that deliver electricity from power plants to end-users. The electrical grid 22 includes power lines, substations, transformers, and other infrastructure necessary for the reliable and efficient delivery of electrical energy.

The electrical output 23 is the electrical power or signal that is generated or transmitted by a device, system, or component as a result of its operation. This electrical output 23 may be in the form of voltage, current, or power, and is typically used to drive other devices, systems, or components.

In the electrical output 23 or nearby the electrical output 23 may be arranged a ore several filter components. Those filter component(s) may have two effects. Firstly, they may enhance the stability of the power supply by decreasing disturbing voltage spikes or electromagnetic waves which may come from outside the container. Secondly, they may reduce disturbing electromagnetic waves which are developed inside the container before they come out. So, they help to reduce electromagnetic disturbing into the load or environment.

In the electrical output 23 or nearby the electrical output 23 may be arranged a ore several measuring components. Those measuring component(s) may help a control to manage the power supplied. A precise control of output power, voltage, or current is possible in such a way.

The pulsed ultra high voltage 26 refers to a high-voltage electrical signal that is characterized by short-duration pulses of extremely high voltage. These pulses are typically used in applications requiring rapid and intense bursts of electrical energy, such as in certain types of scientific research, medical equipment, or industrial processes, in particular plasma processes.

The plurality of electronical components 6 may have two connection points 20 with a shortest distance 25 between them and with that the electrical components 6, each may be configured to generate a moderate high voltage 27.

The plurality of electrical components 6 may be connected electrical in series.

The electrical component 6 should be understood as a component being a part of a power supply with an electrical current running through it, when the power supply is in use, for example, a transistor, a diode, a capacitor, an inductivity.

Plurality of electrical components should be understood as a combination of, for example, transistors, diodes, capacitors, inductivities being a functional part of a power supply.

Further details and functions of such electrical components are explained in EP4487360A1, e.g..

Moderate high voltage 27 refers to an electrical voltage level that is higher than standard operating voltages but not as extreme as ultra high voltages. Each component within a system may have a different moderate high voltage, tailored to its specific operational requirements. The moderate high voltage for each component is determined based on its design specifications and functional needs, ensuring optimal performance and safety.

The HP-HV-pulsed power supply 1 may be configured to deliver electrical power with a pulsed ultra high voltage 26 with a peak output voltage of 2 kV or more.

Peak output voltage refers to the maximum voltage level that an electrical device, system, or component can deliver during its operation. This voltage is typically measured at the highest point of the voltage waveform and represents the maximum electrical potential achieved. Peak output voltage is a critical parameter in the design and performance evaluation of electrical and electronic systems, as it determines the capability of the system to handle high voltage demands. It is commonly expressed in units of volts (V) and is essential for applications requiring precise control of voltage levels, such as power supplies, amplifiers, and signal processing equipment.

Some of the electrical components 6 may be connected electrical in series and in use of the HP-HV-pulsed power supply 1, the peak output voltage will be divided over those components 6 and the highest amount of moderate voltage 27 over each of two connection points of those components is lower than the peak output voltage by a factor of 2 or more.

The HP-HV-pulsed power supply 1 may comprise a pressure management system configured to keep the pressure inside the container 2 in a predefined range through valve 32 with condenser 33.

A pressure management system refers to a set of components and mechanisms designed to regulate and maintain optimal pressure levels within the liquid cooling circuit. This system ensures that the cooling liquid circulates efficiently, preventing issues such as cavitation, leaks, or excessive pressure build-up. By maintaining stable pressure, the system enhances the cooling performance, reliability, and safety of the power supply, ensuring effective thermal management and preventing damage to the cooling components and the power supply itself.

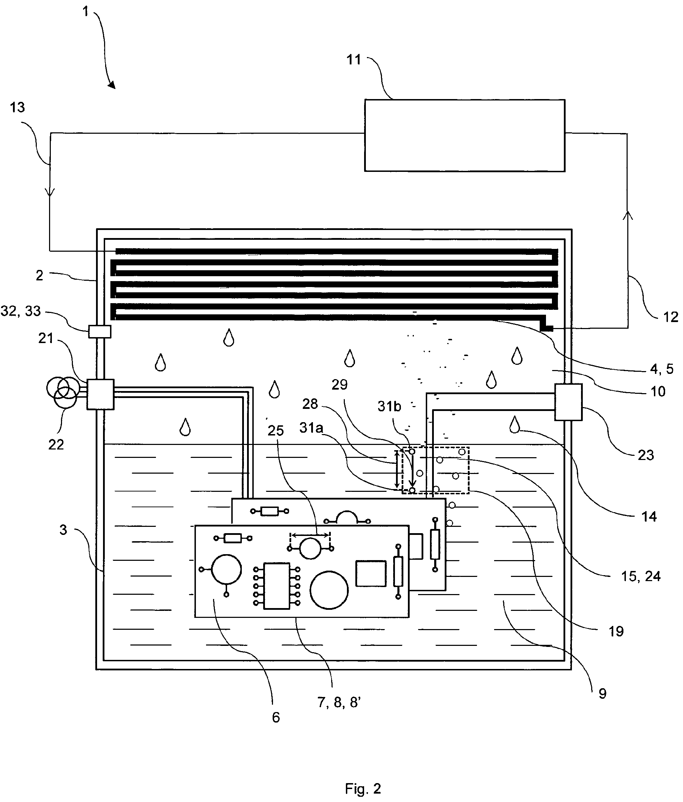

Fig. 2 shows an HP-HV-pulsed power supply 1 for a plasma process as described in fig. 1, where a part of the plurality of electrical components are placed in a basin 3, an electrically insolating heat transfer liquid 9, surrounding and having direct contact to the electrical components 6. The electrically insolating heat transfer liquid 9 is configured to evaporate under the influence of heat from the electrical components to the form of vapor 15 with bubbles 24, which rises up the container 2, to transport heat away from these electrical components 6. A condenser pipe 4 is filled with cooling fluid 5, so that the vapor 15 may condense on the condenser pipe 4 and get back as a droplet 14 to the basin 3.

The "getting back" to the basin may be a "falling back", e.g. as droplets or jet. It may also be a "leading back" along a fluid guidance, such as a runoff, gutter, or gully.

Such a fluid guidance may be arranged and configured to lead the condensed vapor to the basin 3.

The condenser pipe 4 may be arranged above the basin 3.

The condenser pipe 4 may be arranged in the air environment 10.

The electrically insolating heat transfer liquid 9 may be characterized by a breakdown voltage 29 in a field 19. The electrically insolating heat transfer liquid 9 and bubbles 24 of vapor 15 are present.

In the HP-HV-pulsed power supply 1 electrical discharges may occur when the voltage across two points 31a, 31b, with a predetermined distance 28 within a field 19, is higher than the breakdown voltage 29, which may be applied across the two points 31a, 31b. The predetermined distance 28 corresponds to mentioned shortest distance 25 between two connection points of one of the components 6. In the case of Fig. 2 arrangement, the predetermined distance 28 is equal to two connection points of one of the components 6.

In use of the HP-HV-pulsed power supply 1, the highest amount of moderate voltage 27 over two connection points of all components 6 is lower than the said breakdown voltage 29 and the pulsed ultra high voltage 26 may get higher than this breakdown voltage 29. The use of an electrically insulating heat transfer liquid 9 that evaporates upon heating as a vapor 15 may provide an efficient mechanism for transferring heat away from the electrical components 6, thereby maintaining their operational integrity and extending their lifespan.

The incorporation of a heat exchanger 11 may provide the advantage of enhanced conductive heat transfer, allowing for effective dissipation of heat generated by the electrical components 6.

The continuous circulation of the cooling fluid 5 may offer the advantage of renewability in the cooling process, ensuring sustained performance and longevity of the HP-HV-pulsed power supply 1.

The inclusion of a continuous circuit with a heat exchanger 11 may allow for the effective dissipation of heat outside the closed container 2, which can prevent overheating and reduce the thermal load on the system.

The continuous circulation of cooling fluid 5 may ensure a consistent and controlled cooling process, which can improve the reliability and performance of the power supply during prolonged use.

The first pipe 12 and second pipe 13 may facilitate a closed-loop cooling system that can be easily integrated with external cooling infrastructure, providing flexibility in the thermal management of the HP-HV-pulsed power supply 1.

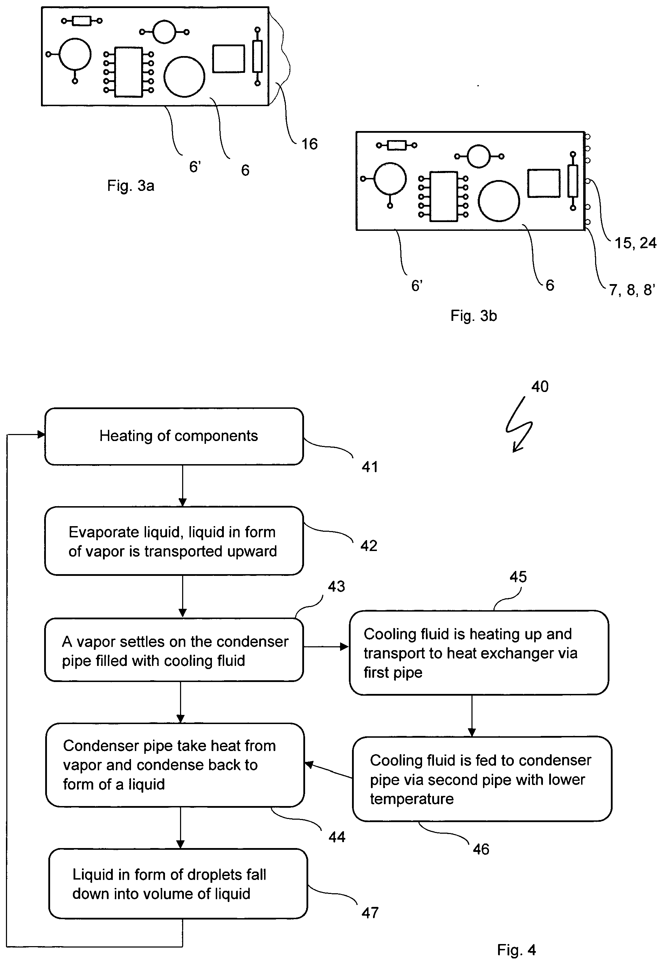

Fig. 3a shows the HP-HV-pulsed power supply 1 which comprises a plurality of electronic components 6 placed in a box 6'. That box 6' has a wall 7. Alternatively, or additionally, the electronic components 6 may have a wall 7 by themselves. On the wall 7, an evaporation effect may be created, where droplets connect with each others and create a cloud of vapor 16.

The cloud of vapor 16 on the wall 7 of the electronic components 6 can lead to corrosion of metal components, reducing their lifespan and reliability and vapor can condense into liquid, causing short circuits and electrical failures. It also can degrade insulation materials, compromising the safety and performance of electrical components. The cloud of vapor 16 can trap heat, leading to overheating and reduced efficiency of cooling systems.

Fig. 3b shows the HP-HV-pulsed power supply 1 which comprises a plurality of electronical components 6 placed in a box 6'. That box 6' has a wall 7 with an additional layer 8 with boiling enhancement coating 8'. Alternatively, or additionally, the electronic components 6 themselves have a wall 7 with an additional layer 8 with boiling enhancement coating 8'. On the wall 7, an evaporation effect with vapor 15 and droplet 24 may be created,

This improves the heat transfer efficiency obtained in the technology of boiling enhancement coating 8'. The additional layer 8 on the wall 7 of the electrical components 6 enhances the boiling enhancement coating 8' technology, which can significantly improve the heat transfer rate and cooling efficiency, and does not allow the formation of a cloud of vapor on the wall 7. Vapor 15 in the form of small droplets 24 may be easy evaporate as described above on fig. 2.

A "boiling enhancement coating" designates a coating, which is applied to the surface of the components, which is in direct contact to the electrically insolating heat transfer liquid, which is configured to enhance the boiling of the electrically insolating heat transfer liquid.

The improved heat transfer efficiency can lead to a more compact and energy-efficient design, as the power supply can operate effectively with less cooling fluid 5 or a smaller cooling system.

The additional layer 8 provides extra protection for the electrical components against thermal stresses and potential damage, contributing to the overall durability and robustness of the power supply.

The heat transfer efficiency can be described by parameters a critical heat flux (CHF) and a heat transfer coefficient (HTC).

A critical heat flux (CHF) refers to the maximum heat flux at which a liquid can be heated before a transition occurs from nucleate boiling to film boiling. The CHF may be a crucial parameter in the design and operation of cooling systems, as exceeding this limit can result in overheating and potential damage to the system. It is typically measured in units of watts per square meter (W/m²).

A heat transfer coefficient is a measure of the heat transfer rate per unit area and per unit temperature difference between a solid surface and a fluid in contact with it.

This special layer improves the heat transfer efficiency obtained in the technology of boiling enhancement coating. There are few special technologies regarding boiling enhancement coatings (BEC):
- extended surfaces - metallic or graphite fins or foams whose primary function is to spread heat over the larger area to a lower heat flux. Application of extended surfaces could sometimes prevent onset of nucleate boiling, leading to high wall superheat;
- microporous organic coatings - offer a moderate increase of CHF and HTC. They biggest advantage is that they can be easily and quickly applied at room temperature;
- microporous metallic coatings - made entirely of high thermal conductivity metals like copper or aluminum. They can produce HTC as high as 10 W/cm²K and extensively increase CHF. Many technologies such as plating, sintering, brazing or plasma spraying can be used to manufacture such coatings.

Fig. 4 shows schematic block of method 40 of cooling an HP-HV-pulsed power supply 1 consists of following steps:
a. a heating step 41, in which an electrical component 6, or a plurality of electrical of components 6, is or are heated,
b. an evaporating step 42, in which the heat generated by the component(s) 6 causes an electrically insolating heat transfer liquid 9 to evaporate and the electrically insolating heat transfer liquid 9 is transported upward in the form of vapor 15,
c. a vapor condenser step 43 in which the vapor 15 settles on a condenser pipe 4, which is filled with cooling fluid 5,
d. a heat receiving step 44 in which the cooling fluid 5, under the action of warm vapor 15, heats up and receives the heat of vapor 15 through the condenser pipe 4,
e. a heat dissipating step 45 in which the cooling fluid 5 in condenser pipe 4 is in continuous circulation and thus dissipates heat from container 2 via first pipe 12 to heat exchanger 11,
f. a fluid fed back step 46 in which the cooling fluid 5 from heat exchanger 11 is fed to the condenser pipe 4 via second pipe 13,
g. a vapor condensed vapor getting back step 47 in which the cooled vapor 15 condenses back into the form of a liquid 9 and falls as droplets 14 into the volume of the liquid 9.

The two-phase cooling method provides a self-regulating cooling process, where the rate of evaporation increases with the temperature of the components, leading to a responsive and efficient cooling mechanism.

The continuous circulation of cooling fluid 5 in the condenser pipe 4 ensures that the heat is consistently removed from the system, preventing localized hotspots and ensuring uniform temperature distribution.

The condensation of vapor 15 back into liquid form within the closed system, e.g., the completely closed container 2, reduces the loss of cooling fluid 5 to a very high degree, making the method cost-effective and environmentally friendly due to reduced need for fluid replenishment.

## Claims

1. An HP-HV-pulsed power supply (1) for a plasma process, said HP-HV-pulsed power supply (1) comprising:
a. an electrical input (21) to receive electrical power from an electrical grid (22),
b. an electrical output (23) to deliver a pulsed ultra high voltage (26),
c. a plurality of electrical components (6), each configured to generate a moderate high voltage (27) between two connection points (20), and being capable to generate heat when the HP-HV-pulsed power supply (1) is in use,
d. a container (2) with a basin (3), wherein said plurality of electrical components (6) are placed in the basin (3),
e. an electrically insolating heat transfer liquid (9) in the basin (3), surrounding and having direct contact to the electrical components (6), wherein the electrically insolating heat transfer liquid (9) is configured to evaporate under the influence of heat from the electrical components (6) to the form of vapor (15), the vapor (15) being able to rise up in the container (2), to transport heat away from the electrical components (6),
f. a condenser pipe (4), fillable with a cooling fluid (5), and configured that the vapor (15) may condense on the condenser pipe (4) and may get back to the basin (3), wherein
g. the HP-HV-pulsed power supply (1) is configured to deliver electrical power with a pulsed ultra high voltage (26) with a peak output voltage of 2 kV or more, and
h. said plurality of electrical components (6) are connected electrical in series, so that, in use of the HP-HV-pulsed power supply (1), the peak output voltage will be divided over those components (6) and the highest amount of moderate voltage (27) over each of two connection points of those components (6) is lower than the peak output voltage by a factor of 2 or more.

2. HP-HV-pulsed power supply (1), according to claim 1, wherein the electrically insolating heat transfer liquid (9) is **characterized by** a breakdown voltage (29) in a field (19) in which both, electrically insolating heat transfer liquid (9) and bubbles (24) of vapor (15) are present, wherein the predetermined distance (28) corresponds to the shortest distance (25) between two connection points of one of the components (6).

3. HP-HV-pulsed power supply (1), according to one of the preceding claims,
wherein in use of the HP-HV-pulsed power supply (1), the highest amount of moderate voltage (27) over two connection points of all components (6) is lower than the said breakdown voltage (29).

4. HP-HV-pulsed power supply (1) according to one of the preceding claims,
wherein in use of the HP-HV-pulsed power supply (1), the pulsed ultra high voltage (26) may get higher than this breakdown voltage (29).

5. The HP-HV-pulsed power supply (1) according to one of the preceding claims, wherein the HP-HV-pulsed power supply (1) comprises a first pipe (12), a heat exchanger (11) and a second pipe (13), the first pipe (12), the heat exchanger (11) and the second pipe (13) arranged in a continuous circuit fillable with the cooling fluid (5), so that in use the cooling fluid (5) conducts the heat generated by the component(s) (6) outside the container (2).

6. An HP-HV-pulsed power supply (1) according to one of the preceding claims, wherein the condenser pipe (4) is in the form of a spiral.

7. An HP-HV-pulsed power supply (1) according to one of the preceding claims, wherein the container (2) is a completely closed container.

8. An HP-HV-pulsed power supply (1) according to one of the preceding claims, wherein the HP-HV-pulsed power supply (1) comprises a pressure management system configured to keep the pressure inside the container (2) in a predefined range.

9. An HP-HV-pulsed power supply (1) according to one of the preceding claims, wherein the HP-HV-pulsed power supply (1) comprises a pressure management system configured to keep the pressure inside the container (2) through valve (32) with condenser (33).

10. An HP-HV-pulsed power supply (1) according to one of the preceding claims,
wherein the electrically insolating heat transfer liquid (9) is a fluorocarbon-based fluid.

11. An HP-HV-pulsed power supply (1) according to one of the preceding claims,
wherein the wall (7) comprises a layer (8) with boiling enhancement coating (8').

12. Method (40) of cooling an HP-HV-pulsed power supply (1), in particular a HP-HV-pulsed power supply (1) for a plasma process, preferred according to one of the preceding claims, wherein the method consists of following steps:
a. a heating step (41), in which a electrical component (6), or a plurality of electrical components (6), is or are heated,
b. an evaporating step (42), in which the heat generated by the component(s) (6) causes an electrically insolating heat transfer liquid (9) to evaporate and the electrically insolating heat transfer liquid (9) is transported upward in the form of vapor (15),
c. a vapor condenser step (43) in which the vapor (15) settles on a condenser pipe (4), which is filled with cooling fluid (5),
d. a heat receiving step (44) in which the cooling fluid (5), under the action of warm vapor (15), heats up and receives the heat of vapor (15) through the condenser pipe (4),
e. a heat dissipating step (45) in which the cooling fluid (5) in condenser pipe (4) is in continuous circulation and thus dissipates heat from container (2) via first pipe (12) to heat exchanger (11),
f. a fluid fed back step (46) in which the cooling fluid (5) from heat exchanger (11) is fed to the condenser pipe (4) via second pipe (13),
g. a vapor condensed vapor getting back step (47) in which the cooled vapor (15) condenses back into the form of a liquid (9) and falls as droplets (14) into the volume of the liquid (9).
